# EUROPEAN PATENT APPLICATION

(11) **EP 4 782 919 A2**
(43) Date of publication of application: **29.07.2026**
(21) Application number: 26184886.5
(22) Date of filing: 12.06.2026
(51) Int. Cl.: G03F 7/00

(54) **PHOTONIC CRYSTAL SURFACE EMITTING LASER-BASED METROLOGY ASSEMBLY**

(71) Applicant: ASML Netherlands B.V., 5500 AH Veldhoven (NL)
(72) Inventor: ROSCAM ABBING, Sylvianne, Dorothea, Christina, 5500 AH Veldhoven (NL); O'DWYER, David, 5500 AH Veldhoven (NL); VAN ENGELEN, Jorn, Paul, 5500 AH Veldhoven (NL); ZHOU, Zili, 5500 AH Veldhoven (NL); INVERNIZZI, Andrea, 5500 AH Veldhoven (NL)
(74) Representative: ASML Netherlands B.V.

(57) **Abstract**

Metrology assemblies for measuring a parameter of a substrate, the metrology assembly comprising a photonic crystal surface emitting laser PCSEL configured to output radiation and a photonic integrated circuit PIC. The PCSEL is directly attached to a back surface of the PIC. The metrology assembly is configured to direct the radiation from the PCSEL to the substrate. The PIC has at least one input coupler configured to capture at least some of the radiation after it has interacted with the substrate. A detector configured to receive at least some of the captured radiation from the PIC for measuring the parameter.

## Description

### FIELD

The present invention relates to metrology assemblies for measuring a parameter of a substrate. Specifically, it relates to metrology assemblies comprising integrated optics and a Photonic Crystal Surface Emitting Laser PCSEL radiation source.

### BACKGROUND

In semiconductor device manufacturing processes, apparatuses can be used to process and/or assess objects such as a substrate or a patterning device. An example of such an apparatus is an exposure apparatus used to generate interactions between a radiation, for example an electromagnetic radiation or a charged-particle radiation, with a substrate or a patterning device. Other examples of such apparatuses are a deposition apparatus, an etching apparatus, and a die-bonding apparatus. A lithographic apparatus and an assessment apparatus are examples of an exposure apparatus. A lithographic apparatus, for example a deep ultraviolet (DUV) lithographic apparatus, an extreme ultraviolet (EUV) lithographic apparatus or a charged-particle lithographic apparatus, may use an electromagnetic radiation or a charged-particle radiation to form a pattern onto a layer of radiation-sensitive material, for example a layer of photo resist, provided on a substrate. An assessment apparatus, for example an inspection apparatus or a metrology apparatus, may form interaction products resulting from interaction of an electromagnetic radiation or charged-particle radiation with an object such as a substrate or a patterning device, thereby detecting defects such as particles, or measuring a parameter of interest such as a critical dimension, for example.

As part of semiconductor device manufacturing, a substrate may be measured at various stages of the patterning process. Measurements of a substrate may be performed by a metrology tool or an inspection tool comprising one or more sensors. To provide high quality process control of the semiconductor patterning process, metrology sensors may be provided inside a patterning device, and may be integrated into them. As the sizes of the structures to be patterned on the substrate decrease, sensors that measure the substrate have become more accurate and precise, reaching a higher resolution. This increase in performance may be accompanied by an increase in complexity of the sensor and metrology tool. The present disclosure provides improved assemblies for metrology applications, such as metrology applications in semiconductor device manufacturing.

### SUMMARY

According to an aspect of the current disclosure, there is provided a metrology assembly for measuring a parameter of a substrate. The metrology assembly comprises a photonic crystal surface emitting laser PCSEL configured to output radiation, and a photonic integrated circuit PIC. The PCSEL is directly attached to a back surface of the PIC. The metrology assembly is configured to direct the radiation from the PCSEL to the substrate. The PIC has at least one input coupler configured to capture at least some of the radiation after it has interacted with the substrate. The metrology assembly further comprises a detector configured to receive at least some of the captured radiation from the PIC for measuring the parameter.

Optionally, the PIC may be configured to receive radiation from the PCSEL and direct at least some of the radiation to the substrate via at least one output coupler of the PIC.

Optionally, the PIC may have an input grating coupler configured to receive radiation from the PCSEL.

Optionally, the PIC may comprise one or more waveguides configured to direct at least some of the radiation from the input grating coupler to the at least one output coupler.

Optionally, a metamaterial may be positioned between an output of the PCSEL and the PIC. The metamaterial may be configured to shape the wavefront of the radiation output by the PCSEL to couple it into the PIC.

Optionally, the PCSEL may be a modulated photonic crystal surface emitting laser M-PCSEL.

Optionally, the PIC may comprise a plurality of input grating couplers configured to capture radiation from the substrate.

Optionally, the PIC may comprise one or more reference waveguides configured to guide a portion of the radiation from the PCSEL to one or more reference branches.

Optionally, the PIC may be configured to interfere captured radiation from the substrate with the radiation from the one or more reference branches to form an interference pattern on the detector.

Optionally, the detector may be configured to extract at least one of phase information and amplitude information from the interference pattern for determining the parameter.

Optionally, the PIC may comprise a plurality of waveguides configured to direct at least some of the radiation received from the PCSEL to a plurality of output couplers configured to direct radiation to the substrate.

Optionally, the plurality of grating couplers may be configured to direct radiation having different angles of incidence onto the substrate.

Optionally, a PIC may comprise an opening, wherein the PCSEL is directly attached to a back surface the PIC. The PCSEL may be configured to output radiation through the opening for directing to the substrate.

According to another aspect of the current disclosure, there is provided a metrology assembly for measuring a parameter of a substrate. The metrology assembly comprises a PCSEL configured to output radiation and a PIC. The PCSEL is directly attached to a front surface of the PIC. The PCSEL is configured to direct at least some of the radiation to the substrate. The PCSEL is a modulated-photonic crystal surface emitting laser M-PCSEL and/or a metamaterial is placed between an output of the PCSEL and the substrate. The PIC has at least one input coupler configured to capture radiation that has interacted with the substrate. The metrology assembly further comprises a detector configured to receive at least some of the captured radiation from the PIC for measuring the parameter.

Optionally, the PCSEL may have a metamaterial placed between an output of the PCSEL and the substrate. The metamaterial may be a metasurface layer configured to direct radiation from the PCSEL to the substrate.

Optionally, the PCSEL may be a modulated PCSEL M-PCSEL configured to output radiation with a non-flat wavefront.

According to another aspect of the current disclosure there is provided a metrology assembly for measuring a parameter of a substrate. The metrology assembly comprises a PCSEL configured to output radiation and a PIC. The PCSEL is directly attached to a side surface of the PIC. The PIC is configured to receive radiation from the PCSEL and direct at least some of the radiation to the substrate via at least one output coupler of the PIC. The PIC has at least one input coupler configured to capture radiation that has interacted with the substrate. The metrology assembly further comprises a detector configured to receive at least some of the captured radiation from the PIC for measuring the parameter.

Optionally, the metrology assembly may comprise a plurality of PCSELs.

Optionally, at least one PCSEL of the plurality of PCSELs outputs radiation that has a different wavelength to at least one other PCSEL of the plurality of PCSELs.

Optionally, the plurality of PCSELs may be located side by side on a front surface of the PIC.

Optionally, the PCSEL may comprise a large illumination numerical aperture.

Optionally, the PIC may comprise a grid of input couplers.

Optionally, the parameter may be substrate alignment. Optionally, the parameter may be overlay.

Optionally, the substrate may comprise a diffraction-based metrology target or a phase aware target.

Optionally, the output coupler may be a grating coupler. Optionally, the input coupler may be a grating coupler.

Optionally, the PIC may comprise one or more waveguides configured to direct at least some of the captured radiation to the detector.

Optionally, the PCSEL may be configured to output continuous wave radiation.

Optionally, the continuous wave radiation may have an average power in a range of 80 µW to 320 mW.

Optionally, the PCSEL may be configured to output pulsed radiation.

Optionally, the pulsed radiation may have a peak power in a range of 80 mW to 320 W.

Optionally, the pulsed radiation may have an average power in a range of 1 mW to 10 W.

Optionally, the PCSEL may be configured to output narrowband radiation or substantially single wavelength radiation.

Optionally, the PCSEL may be configured to output radiation with a wavelength in a range of 250 nm to 1550 nm.

Optionally, the PIC may comprise one or more of silicon Si, silicon dioxide SiO₂, indium phosphor InP, silicon nitride SiN, lithium niobate LiNbO₃ structures.

Optionally, the PCSEL may be directly attached to a back surface or a front surface of the PIC via flip-chip bonding.

Optionally, the substrate may be a lithographically patterned substrate. Optionally, the substrate may be a bonded substrate.

According to another aspect of the current disclosure, there is provided a metrology apparatus comprising a metrology assembly as described herein. The metrology apparatus may be a substrate alignment tool (wafer alignment tool) or an overlay metrology tool.

According to another aspect of the current disclosure, there is provided an inspection apparatus comprising a metrology assembly as described herein.

According to another aspect of the current disclosure, there is provided a semiconductor processing apparatus, a lithography apparatus, or a litho cell comprising a metrology assembly as described herein.

### BRIEF DESCRIPTION OF THE DRAWINGS

Embodiments of the invention will now be described, by way of example only, with reference to the accompanying schematic drawings, in which:
- Figure 1(a) and Figure 1(b) depict a representation of a lithographic apparatus and an assessment apparatus respectively;
- Figure 2 depicts a schematic overview of a lithographic cell;
- Figure 3 depicts a schematic overview of a "holistic" control environment;
- Figure 4 depicts a schematic representation of four different surface emitting laser radiation source options;
- Figure 5 depicts a schematic representation of a metrology assembly for measuring a parameter of or associated with a substrate;
- Figures 6(a) and (b) depict schematic representations of embodiments of a metrology assembly for measuring a parameter of or associated with a substrate;
- Figure 7 depicts a schematic representation of another embodiment of a metrology assembly for measuring parameter of or associated with a substrate;
- Figure 8 depicts a schematic representation of another embodiment of a metrology assembly for measuring parameter of or associated with a substrate;
- Figure 9 depicts a schematic representation of another embodiment of a metrology assembly for measuring parameter of or associated with a substrate;
- Figure 10 depicts a schematic representation of another embodiment of a metrology assembly for measuring parameter of or associated with a substrate;
- Figure 11 depicts a schematic representation of a front surface of a photonic integrated circuit comprising two PCSELs directly attached to it;
- Figure 12(a) depicts a schematic representation of a metrology assembly for measuring an overlay parameter, Figure 12(b) depicts a schematic representation of a diffraction-based metrology target; Figure 12(c) depicts a schematic representation of a phase aware metrology target;
- Figure 13 depicts a schematic representation comprising a PCSEL having a large illumination numerical aperture;
- Figure 14 depicts a schematic representation of positions of a plurality of side by side PCSELS and input couplers; and
- Figure 15 depicts a schematic representation of a metrology assembly comprising multiple PCSELs.

### DETAILED DESCRIPTION

Electromagnetic radiation as used in an exposure apparatus may include for example infrared (IR) light, visible light, ultraviolet or deep ultraviolet radiation (DUV), e.g. with a wavelength of 436, 365, 248, 193, 157 or 126 nm, broadband ultraviolet radiation (e.g. with wavelengths of 290-380 nm), extreme ultraviolet radiation (EUV), e.g. with a wavelength in the range of about 2-20 nm, or X-ray radiation. In a lithographic apparatus, the wavelength of this radiation determines the minimum size of features which can be formed on the substrate. An EUV lithographic apparatus which uses, for example, radiation with a wavelength of 6.7 nm or 13.5 nm, may be used to form smaller features on a substrate than a lithographic apparatus which uses, for example, radiation with a wavelength of 193 nm. The radiation may be in the form of a radiation beam where energy of the radiation is focused and/or directed. Charged-particle radiation as used in an exposure apparatus may be for example an electron beam, an ion beam, or other charged-particle beam.

A radiation source may be used to generate radiation for use in an exposure apparatus. The radiation source may be a laser produced plasma (LPP) source, a discharge produced plasma (DPP) source, a free electron laser (FEL) source, a charged-particle source, or any other radiation source that is capable of generating EUV radiation. The radiation source SO may also be a mercury lamp, an excimer laser source, a solid-state laser source, or other radiation source that is capable of generating IR light, visible light, ultraviolet or DUV radiation. The radiation source may also be a charged-particle source, for example an electron beam source, an ion beam source.

The term 'patterning device' as employed in this text may be broadly interpreted as referring to an object that can be used to endow an incoming radiation with a patterned cross-section, for the purpose of creating a pattern in a target portion of a substrate. Besides the classic mask or reticle (transmissive or reflective, binary, phase-shifting, hybrid, etc.), examples of other such patterning devices include a programmable mirror array, a programmable LCD array, and a (nano)imprint template.

The term 'substrate' as employed in this text may be broadly interpreted as referring to an object on which a pattern may be, or has been, created, an exposure may be performed, or another substrate may be bonded. Examples include a semiconductor substrate and a substrate made of other, non-semiconductor material (e.g. a glass substrate). The semiconductor substrate may be a wafer, such as a silicon wafer, for example. Alternatively or additionally, the substrate may include other semiconductor and/or non-semiconductor materials, such as germanium (Ge) or carbon (C). In some embodiments, the semiconductor substrate is made of a compound semiconductor such as III-V compound semiconductors, II-V compound semiconductors, and/or any suitable integration of Group IV materials. In some embodiments, the substrate may be a silicon-on-insulator (SOI) or a germanium-on-insulator (GOI) substrate. For the purposes of the present disclosure, a substrate and a patterning device as referred to above may be considered as examples of objects intended for use in an apparatus for semiconductor manufacturing processes.

A semiconductor device made from a substrate may have various device elements. Examples of semiconductor device elements that are formed over the substrate include transistors (e.g., planar or non-planar metal oxide semiconductor field effect transistors (MOSFET), bipolar junction transistors (BJT), high-voltage transistors, high-frequency transistors, etc.), diodes, CMOS image sensors, passive devices, and/or other applicable elements. Various processes may be performed to form the semiconductor device elements, such as deposition, etching, implantation, epitaxial growth, polishing, thermal treatment, bonding, and/or other suitable processes. In some embodiments, the substrate is coated with a photoresist layer sensitive to DUV or EUV radiation.

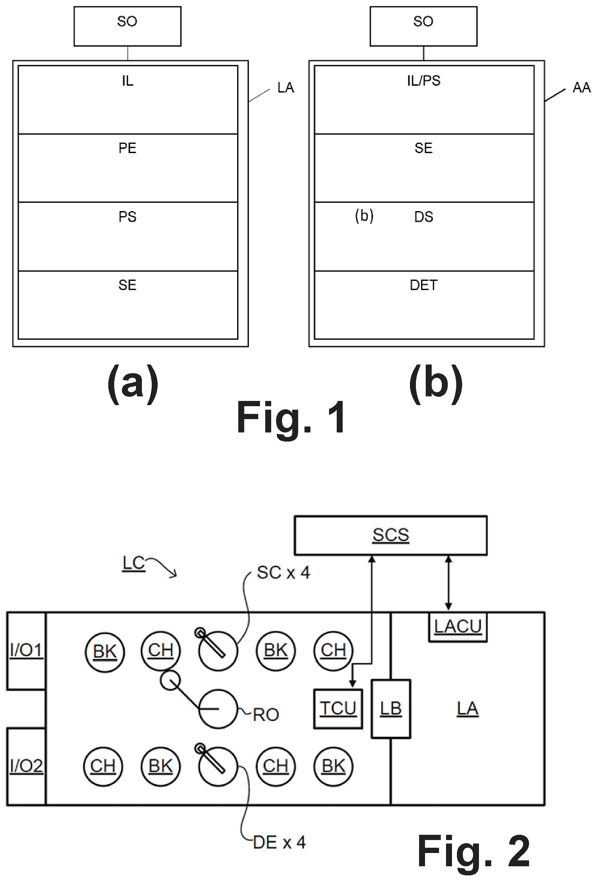

Figure 1(a) shows a lithographic apparatus LA. The lithographic apparatus may comprise a radiation source SO which is configured to generate a radiation, for example a DUV or EUV radiation beam. The lithographic apparatus LA comprises an illumination system IL which receives said radiation from the radiation source SO, e.g. via a beam delivery system. The lithographic apparatus further comprises a patterning environment PE in which a patterning device (e.g., a mask or a reticle) may be provided, a projection system PS, and a substrate environment SE in which a substrate (e.g., a resist coated semiconductor wafer) may be provided.

The illumination system IL is configured to condition the radiation beam before the radiation beam B enters the patterning environment. The illumination system IL may include various types of optical components, such as refractive, reflective, magnetic, electromagnetic, electrostatic, and/or other types of optical components, or any combination thereof, for directing, shaping, and/or controlling radiation. The illumination system IL may be used to condition the radiation beam to have a desired spatial and angular intensity distribution in its cross section at a plane of the patterning device.

After being thus conditioned, the radiation beam enters the patterning environment PE, where it may interact with the patterning device (e.g., a mask or a reticle). As a result of this interaction, a patterned radiation beam is generated. The projection system PS is configured to further direct, shape, and/or control the patterned radiation beam such that it enters the substrate environment SE where it may be projected onto the substrate. The projection system PS may include various types of optical components, including refractive, reflective, catadioptric, anamorphic, magnetic, electromagnetic and/or electrostatic optical components, as appropriate for the exposure radiation being used and/or in consideration of other factors such as the use of an immersion liquid or the use of a vacuum.

Figure 1(b) illustrates an assessment apparatus AA. Similar to the lithographic apparatus LA as depicted in Figure 1(a), the radiation source SO is optional and is configured to generate the radiation. The assessment apparatus AA may include an illumination system IL and/or projection system PS to direct the radiation produced by the radiation source SO to a part of the substrate within the substrate environment SE. The illumination and/or projection system IL/PS may the same as the illumination system IL or the projection system PS of the lithographic apparatus of Fig 1(a). This illumination and/or projection system IL/PS is optional; in one example, the radiation from the radiation source SO is directed straight to the substrate, with no intervening components.

After interacting with the part of the substrate, the scattered, e.g. diffracted, radiation is detected by a detector DET to obtain measured data. In one example, there may be a detection system DS which may be configured to direct the scattered radiation to the detector DET. The measured data may be processed by the assessment apparatus to generate, for instance, an image representation of the part of the substrate.

An assessment apparatus embodied as an inspection apparatus may be used to detect the presence and/or classification of contaminations, defects, and abnormalities in a substrate or a patterning device, with particles being one example of contamination. An assessment apparatus embodied as a metrology apparatus may be used to determine a parameter related to the substrate or the apparatus used to process the substrate, such as the lithographic apparatus used for exposure of the substrate. Measurement from the metrology apparatus may provide feedback to the lithographic apparatus to compensate for any measured drift or other process deviations.

The assessment apparatus may assess a latent pattern (pattern in a resist layer after the exposure), a semi-latent pattern (pattern in a resist layer after a post-exposure bake step, PEB), a developed resist pattern (where the exposed or unexposed portions of the resist have been removed), an etched pattern (e.g., after a pattern transfer step such as etching), or a deposited pattern (e.g., generated by deposition of a metal layer).

An inspection and/or metrology apparatus may be integrated into the lithographic apparatus LA, or may function as a stand-alone device.

As shown in Figure 2, the lithographic apparatus LA may form part of a lithographic cell LC, also sometimes referred to as a lithocell or (litho)cluster, which often also includes apparatus to perform pre- and/or post-exposure processes on a substrate. These may include spin coaters SC to deposit resist layers, developers DE to develop exposed resist, chill plates CH and bake plates BK, e.g. for conditioning the temperature of substrates e.g. for conditioning solvents in the resist layers. A substrate handler, or robot RO picks up substrates from input/output ports I/O1, I/O2, moves them between the different process apparatus and delivers the substrates to a loading bay LB of the lithographic apparatus LA. The aforementioned modules in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates as exposed by the lithographic apparatus LA to be exposed correctly and consistently, it is desirable to assess the substrates by, for example, measuring properties of patterned structures, such as overlay between subsequent layers, and critical dimensions, etc. For this purpose, a metrology apparatus, as described above (not shown), may be included in the lithocell LC. An outcome may be used to adjust exposures of subsequent substrates or other processing steps that are to be performed on the substrates, especially if the metrology measurement is done before other substrates of the same batch or lot are still to be exposed or processed.

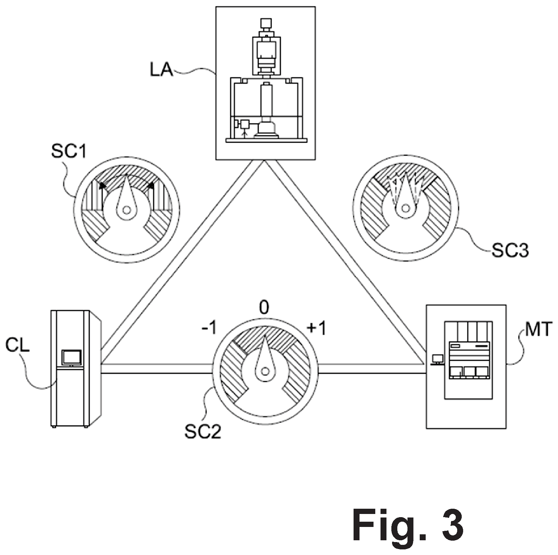

Typically the patterning process in a lithographic apparatus LA is one of the most critical steps in the processing which requires a high accuracy of dimensioning and placement of structures on the substrate. To ensure this high accuracy, three apparatus/systems may be combined in a so called "holistic" control environment as schematically depicted in Figure 3. One of these apparatus/systems is the lithographic apparatus LA which is (operatively) connected to an assessment apparatus, such as a metrology apparatus MT, and to a computer apparatus CL. The key of such "holistic" environment is to optimize the cooperation between these three apparatuses to enhance the overall process window and provide tight control loops to ensure that the patterning as performed by the lithographic apparatus LA stays within a process window. The process window defines a range of process parameters (e.g. dose, focus, overlay) within which a specific processing process yields a defined result (e.g. a functional semiconductor device) - typically within which the process parameters in the patterning process are allowed to vary. The lithographic apparatus LA may also be replaced by another apparatus, for example the etching apparatus.

The computer apparatus CL may use (part of) the design layout to be patterned to predict which resolution enhancement techniques to use and to perform computational lithography simulations and calculations to determine which mask layout and lithographic apparatus parameters achieve the largest overall process window of the patterning process (depicted in Figure 3 by the double arrow in the first scale SC1). Typically, the resolution enhancement techniques are arranged to match the patterning possibilities of the lithographic apparatus LA. The computer apparatus CL may also be used to detect where within the process window the lithographic apparatus LA is currently operating (e.g. using input from the assessment apparatus) to predict whether error may be present due to e.g. sub-optimal processing (depicted in Figure 3 by the arrow pointing "0" in the second scale SC2). The metrology apparatus may provide input to the computer apparatus CL to enable accurate simulations and predictions, and may provide feedback to the lithographic apparatus LA to identify possible drifts (depicted in Figure 3 by the multiple arrows in the third scale SC3).

As shown in Figure 3, a metrology apparatus, such as a metrology tool or an inspection tool, may be operatively connected to a lithographic apparatus and/or any other semiconductor patterning device. Operatively connected to may include being comprised within, and/or integrated in the semiconductor patterning device. The metrology apparatus may for example be configured to measure one or more of alignment, overlay, levelling, dose, and critical dimension.

In one example, the metrology apparatus may be a substrate alignment sensor, sometimes referred to as a wafer alignment sensor, which may be advised to determine an exact position of the substrate with respect to an imaging wavefront of a lithographic apparatus. An imaging wavefront may be used to irradiate a pattern onto the substrate. As the size of the features patterned onto the substrate decreases, the accuracy and precision of the sensor(s) used inside a semiconductor patterning device should also increase, to reach a higher resolution. Such an increase in performance may mean an increasing complexity of both the patterning device and the measurement apparatus. In the example of the substrate alignment tools, the number of available wavelengths (or "colours") to measure the substrate position may be increased as resolution increases. The addition of more wavelengths increases complexity and cost of the wafer alignment sensor. A further challenge may be that increased complexity can also lead to an increased size of the sensor, which may be problematic for placing such a sensor inside a patterning or metrology device where available space may be limited.

In another example, the metrology apparatus may be an overlay metrology tool. An overlay metrology tool may comprise an overlay sensor. Sometimes, the terms overlay sensor and overlay metrology tool may be used interchangeably to refer to any measurement assembly configured to measure overlay. An overlay sensor may use optical metrology to inspect and characterize one or more geometrical properties of semiconductor substrates referred to as overlay. Overlay may describe a lateral misalignment between different layers of the semiconductor substrate. This misalignment may occur due to misalignment between different steps in the semiconductor fabrication cycle. Overlay metrology may use for example an overfilled diffraction-based scatterometry approach, or an underfilled scanning approach. Overfill may refer to a measurement scenario in which the radiation spot is larger than the target to be measured. Underfill may refer to a measurement scenario in which the radiation spot is smaller than the target to be measured. As with an alignment sensor, it may be desirable to reduce the complexity and/or cost of an overlay metrology sensor.

One option for reducing the complexity and cost of a substrate alignment sensor and/or an overlay sensor may rely on using photonic integrated circuits PICs. PICs may replace the functionality of one or more optical components and achieve an equivalent manipulation of radiation while having a smaller size. Using PICs is not limited or restricted to use in a substrate alignment sensor or overlay sensor, and can be applied to any exposure apparatus. The metrology sensor as described herein may comprise a radiation source for illuminating one or more features of interest. An object of interest may be a feature on a substrate (e.g. a metrology target), or an object such as a stage for holding the substrate. The metrology sensor may further comprise one or more optical elements to interact with the radiation from the radiation source. This interaction may include directing the radiation from the source to illuminate the feature(s) of interest, and/or capturing some of the radiation after it has interacted with the feature of interest and directing it to a detector. The detector may also form part of the metrology sensor. The detector may capture and/or determine one or more characteristics of the radiation, such as amplitude phase polarization, etc. These characteristics may be provided to a computer apparatus for extracting relevant information for the metrology application. As stated above, to save cost and complexity of a sensor, some or all of the optical elements may be implemented as part of a photonic integrated circuit PIC.

In general, fibre couplers and/or grating couplers may be used to input and/or output radiation in to/out of a PIC. Both single wavelength diode lasers (e.g. Distributed Feedback Lasers DFBs, Edge Emitting Lasers EELs, Vertical-Cavity Surface Emitting Lasers VCSELs, Vertical External Cavity Surface Emitting Lasers VECSELs) and broadband radiation sources (e.g. super continuum generated radiation source SCG) may be used to provide radiation for integrated sensors. PICs may be suitable for controlling single wavelength and broadband wavelength radiation. Alternatively, a VCSEL radiation source may be directly bonded onto an integrated circuit (see e.g. Pan, Guanzhong, et al. "Harnessing the capabilities of VCSELs: unlocking the potential for advanced integrated photonic devices and systems." Light: Science & Applications 13.1 (2024): 229). A radiation source may be manufactured onto a PIC directly (see e.g. Han, Yu, et al. "Recent advances in light sources on silicon", Advances in Optics and Photonics 14.3 (2022), 404-454).

Currently used radiation sources have associated challenges. High-power lasers, such as DFBs EELs, SCG sources, may be bulky and unsuitable for applications where space is limited. Their large size may counteract a small footprint of a PIC solution. Due to their large size, such high-power radiation sources may be placed further away from the metrology application, meaning that additional transport may be required to guide the radiation from the source to the PIC. Solutions using VCSELs may overcome this challenge, as VCSELs are much smaller in size. However, VCSELs may be limited in the amount of power they are able to output (e.g. of the order of a few mW) for single mode operation. This may be because higher power present in the source may lead to higher order modes being generated in the VCSEL. A source outputting higher order modes may not be suitable for compact applications, as more complex optics may be required to control the radiation. For example, radiation comprising multiple order modes may not be compatible with metamaterials for wavefront shaping. While VECSELs may be able to produce a higher output power than VCSELs, their large size and architecture comprising external components (e.g. a mirror), may make them unsuitable to be provided in the limited space available at the PIC.

Another challenge may be that the characteristics of the radiation beams provided by some of the radiation sources (e.g. DFBs, EELs) may have an unsuitable shape for coupling into a PIC. DFBs and EELs may have a highly divergent beam profile due to the waveguide structure inside the laser. They may also be elliptical in shape, which may be unsuitable for coupling into single mode fibers, for example. Additional optics may be provided to reshape the radiation beam for optimal coupling to the PIC. VCSELs may also present challenges associated with the beam shape they output. While VCSELs may be able to operate in single mode emission for lower powers, they may still emit under relatively large divergence angles (e.g. 10-20 degrees). As a result, subsequent optics may be required to comment the beam for coupling to a PIC. The addition of optical components for beam shaping can increase the complexity, cost, and size of the metrology sensor. Furthermore, VCSELs are available in a near-infrared near-IR wavelength range, and may have optimised emission ranges for example in a range of 800 nm - 1515 nm wavelength. Due to the geometric dimensions of Bragg mirrors within a VCSEL, it may be challenging to make VCSELs in the visible wavelength regime. This may be because the requirement on layer thickness of the Bragg mirror may become too thin to be manufactured reliably. For example, VCSELS may be commercially available for wavelengths down to 900 nm, and in some early-stage development down to 800 nm.

As an alternative to external radiation sources, research is ongoing for developing a radiation source that can be directly manufactured in/as part of an integrated photonic circuit PIC. However, such integrated sources may be limited to power outputs that are too low for metrology applications. Furthermore, these integrated sources may be restricted in wavelength range due to available substrate materials. Substrate material availability may be especially limited in the visible wavelength range.

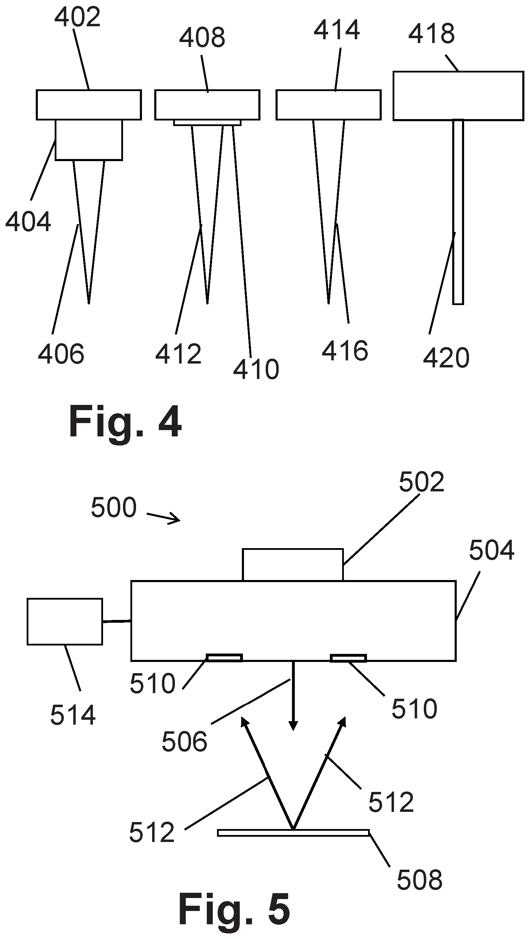

Proposed herein are solutions that address at least some of the challenges associated with the sources used in combination with PICs as described herein . It is presented to use a Photonic Crystal Surface Emitting Laser PCSEL as a radiation source for a PIC for use in a metrology assembly. The metrology assembly may be part of an exposure apparatus, e.g. an assessment apparatus. Figure 4 depicts a schematic representation providing a comparison of 4 different surface emitting laser radiation source options. A first option is a VCSEL 402, which uses a lens 404 to shape radiation 406, for example focusing it onto an input for coupling into a PIC (not shown in Figure 4). Compared to a VCSEL radiation source, a PCSEL radiation source can be more compact in size, especially when it is integrated on a PIC. This may be because VCSELs may output radiation with high divergence. As a result, one or more lenses and/or other optical components may be required to shape the radiation to make it suitable for being coupled into a PIC and/or to make it suitable for illuminating a target. Advantages of PCSELs may include that they can provide high output power, have excellent beam quality, and may be compact in size and/or low in cost, compared to other laser sources. PCSELs may have applications aimed at LiDAR, free-space communication, and/or any replacement of high-power laser systems. High beam quality may for example include a PCSEL with a focus spot of 200 µm x 200 µm and a focus length of 300 µm (which may resemble a numerical aperture NA of 0.3).

PCSELs do not output radiation with high divergence compared to radiation output by VCSELs. For example, a PCSEL may have a divergence angle of a few degrees (e.g. 1 degree) compared to a divergence angle in a range of 10-20 degrees for a VCSEL. In some instances, for example when the PCSEL has a small emission area (e.g. ≤100 µm), the radiation may be suitable for coupling into a PIC without additional beam shaping. This is depicted schematically as PCSEL 418 of Figure 4, emitting radiation 420 with very low divergence. In order to have low divergence, the PCSEL may have a large size, compared to smaller PCSELs which may have larger divergence angles. In other instances, some beam shaping may be required, but this will be less than for VCSELs, and may be suitable to be performed by photonic elements that are significantly more compact than solutions available for VCSELs. For example, metamaterials such as two-dimensional metasurfaces may be used for shaping a radiation beam output by a PCSEL. This is depicted for example in PCSEL 408 of Figure 4, which uses a metamaterial 410 to shape radiation 412. Any of the embodiments described herein may comprise a metamaterial for shaping radiation, either at the PCSEL or elsewhere in the metrology assembly. In another example, a photonic crystal lattice of a PCSEL 414 could be modified to accommodate and emit a non-flat wavefront 416, referred to as Modulated-Photonic Crystal Surface Emitting Lasers M-PCSELs. Grating couplers as described herein may have a specific acceptance angle for incoming radiation that will be non-perpendicular to the surface of the PIC. The photonic crystal lattice on an M-PCSEL may be designed to have emission angle to optimize coupling into the grating coupler at its preferred acceptance angle. This emission angle may in some instances be programed in polar coordinates (theta, phi) to allow for more efficient PIC in-coupling. The PCSELs and PIC as described herein may be provided as part of a metrology assembly for a variety of metrology applications, for example related to a semiconductor patterning process. Compared to the different PCSEL solutions 408, 414, and 418 of Figure 4, the VCSEL option 402 using lens 404 is significantly more bulky and less compact in size.

Figure 5 depicts a schematic representation of a first embodiment of metrology assembly 500 for measuring a parameter of a substrate 508. The metrology assembly comprises a PCSEL 502 configured to output radiation. The metrology assembly further comprises a PIC 504. The PCSEL may be directly attached to a back surface of the PIC. The metrology assembly is configured to direct radiation 506 from the PCSEL to the substrate. The substrate may be located at the side of a front surface of the PIC. The PIC has at least one input coupler, or referred as in-coupler, 510 configured to capture at least some of the radiation 512 after it has interacted with the substrate. The input coupler may be provided on a front surface of the PIC. In one embodiment, the metrology assembly further comprises a detector 514 configured to receive at least some of the captured radiation from the PIC for measuring the parameter. In one embodiment, the detector is configured to extract at least one of phase information and amplitude information for determining the parameter.

A metrology assembly having features as set out in the paragraph above may have an advantage of being compact in size. The metrology assembly provides a PIC, which is compact compared to traditional optics. The PCSEL may have properties as described in relation to Figure 4, making it a compact and suitable source. Directly attached, in this instance, may be understood as either including or not including a metamaterial layer for shaping the radiation beam, as the metamaterial layer may be considered to form part of the PCSEL source. Directly attached may also be understood as meaning that the PCSEL is integrated onto the PIC, to form an integrated metrology assembly. The integrated metrology assembly may also be referred to as a monolithically bonded assembly. As both PCSELs and PICs may be produced at low cost and complexity relative to non-integrated alternatives, another advantage of the metrology assembly described herein may be a relatively low cost compared to metrology assemblies not comprising an integrated PCSEL and PIC combination. Another advantage of using a PCSEL may be that it can provide high power radiation with a high quality and controllable beam profile.

The PIC may be configured to receive and direct at least some of the radiation output by the PCSEL. The radiation may be received by the PIC directly from the PCSEL and/or may be received after the radiation has interacted with one or more other elements. The PIC may comprise one or more waveguides. The PIC may comprise one or more in-couplers, also referred to as input couplers, for receiving radiation and coupling it into a waveguide of the PIC. The PIC may comprise one or more out-coupler, also referred to as output couplers, for directing radiation out of the PIC. The in-couplers and out-couplers may be grating in-couplers and grating out-couplers, respectively. Grating couplers may be advantageous for coupling radiation to/from free space. Alternatives to grating couplers include 3D printed waveguides, lenses, and/or mirrors, or elliptical tapers and/or lens patterns that may be part of the waveguide patterns in the PIC.

The size of two of the dimensions of the PIC may be significantly greater than a third dimension of the PIC. The two larger dimensions form front and back surfaces of the PIC. The third dimension, perpendicular to the plane formed by the first two dimensions, may be referred to as a height of the PIC. The height of the PIC may be uniform or non-uniform across the surfaces of the PIC. For example, the PIC may have stepwise changes in height. The walls along the height of the PIC may be referred to as the sidewalls of the PIC. A front surface of the PIC may be a surface that faces towards the substrate to be measured. The front surface may be referred to as the emitting surface. The front surface may optionally comprise structures for coupling radiation into the PIC, and may optionally have structures for coupling radiation out of the PIC. A back surface may be the surface of the PIC on the opposite side of the front surface. The back surface may be facing away from the substrate to be measured.

The substrate to be measured may be a semiconductor substrate. The substrate may be a patterned, partially patterned or un-patterned substrate. Determining a parameter of the substrate may involve determining a parameter of a pattern or partial pattern on a substrate. In some instances, determining a parameter of a substrate may involve determining a parameter of a substrate associated with the environment it is located in, such as for example position of the substrate relative to a wafer stage, temperature, pressure, etc.

The radiation may be used to illuminate one or more structures of interest on the substrate. A structure of interest may for example comprise a metrology target, an area of the substrate at the edge or in the middle of the substrate, a feature patterned on the substrate, and/or an unpatterned area of the substrate. Radiation may be scattered, reflected, and/or diffracted by the substrate. Scattering and/or diffraction of radiation by the substrate may occur in transmission and/or reflection. The metrology target may for example include a target over several layers in the substrate, such as an overlay target. The metrology target may be a phase aware target.

PCSELs may be combined with a metamaterial that performs beam shaping radiation control for obtaining a desired wavefront shape. The metamaterial may be very compact in size compared to other optics. The metamaterial may for example be a metasurface, which may have a substantially planar (rigid or flexible) shape. A standard PCSEL may be combined with a metamaterial to modify the phase and/or amplitude of radiation output by the PCSEL. While it may be possible in some instances to use a metamaterial for shaping radiation from a VCSEL, this would only work for low power applications (e.g. up to a few mW, e.g. up to 10 mW). This limitation to low power applications may be because higher powers may lead to higher order modes in a VCSEL, which may be incompatible with current metamaterial radiation control applications. Examples of how metamaterials can be used to condition and shape radiation can be found for example in Pan, Guanzhong, et al. "Harnessing the capabilities of VCSELs: unlocking the potential for advanced integrated photonic devices and systems." Light: Science & Applications 13.1 (2024): 229; and in Pan, Meiyan, et al. "Dielectric metalens for miniaturized imaging systems: progress and challenges." Light: Science & Applications 11.1 (2022): 195.

Alternatively or additionally to using a metamaterial, radiation for a metrology assembly as described herein may be shaped by providing a modulated photonic crystal surface emitting laser M-PCSEL. M-PCSELs may be specialised PCSELs that have a photonic crystal lattice structure that has been adapted to accommodate a non-flat wavefront of radiation. The adaptation may for example include a diffraction pattern that has been included inside the photonic crystal lattice of the PCSEL to modulate the radiation output by the M-PCSEL. The photonic crystal lattice can be adapted to enable transmission of radiation in arbitrary directions and wavefront shapes without requiring external optics, as described for example in Noda, Susumu, et al. "Photonic-crystal surface-emitting lasers." Nature Reviews Electrical Engineering 1.12 (2024): 802-814. By modulating the wavefront, the M-PCSEL may be configured to output radiation that has properties desirable and/or required for intended use as part of the metrology assembly.

Next to providing a metamaterial in combination with a PCSEL, a metamaterial could also be provided to shape the wavefront of radiation in another part of the metrology assembly. For example, a metamaterial may shape the wavefront of radiation anywhere in the PIC, before or after interacting with the substrate, and/or at the detector. Wavefront shaping of radiation, by a metamaterial or otherwise, may be performed to improve the sensitivity of the system to the parameter of interest. Wavefront shaping may additionally or alternatively be performed to make the measurement more robust, for example against tilt and/or defocus of the substrate. In an example, grating in- and/or out-couplers may be optimized to find a balance between a combination of efficiency of in/out coupling, sensitivity to the parameter to be measured, and/or robustness of the measurement.

Measuring the parameter may comprise processing the captured radiation from the detector and determining one or more properties of this radiation, such as for example amplitude-, phase-, and/or polarization- distribution across the detector. The parameter of the substrate may be determined based on this information, for example by a processing unit, which may comprise a computer processor. The processing unit may be present as part of the metrology assembly or may be connected to it, e.g. via a wired and/or wireless connection.

The metrology assembly may comprise one or more detectors configured to receive at least some of the captured radiation that has interacted with the substrate to be measured. A detector (e.g. a camera) may determine a distribution of intensity of radiation incident on a sensor area of the detector. Alternatively or additionally, a detector (e.g. a photodiode) may detect variations in intensity. A captured intensity distribution of radiation may be used to determine intensity and/or phase and/or polarization information, for example through the use of measuring interference patterns. In some instances, such interference patterns may be measured directly on the detector, or in other instances the interference patterns may be created earlier in the radiation path (e.g. inside the PIC) and may subsequently be (indirectly) captured by the detector, e.g. via a fibre. The detector may directly measure a parameter and/or a detector may determine a parameter based on measured information, e.g. through calculations using the measured information and/or processing of the measured information. The processing may be performed at the detector, or it may be performed at a separate processing entity (e.g. a computer system) which may be connected to the detector and receive measured information from the detector.

The PIC may combine radiation captured by multiple grating input couplers (or referred to as input grating couplers or grating in-couplers) to produce one or more radiation signals for the detector. The substrate may comprise a structure such as a metrology target comprising one or more gratings, e.g. diffraction gratings. It may be advantageous to capture multiple diffraction orders that have been diffracted by the substrate. The PIC may for example be configured to capture the positive first +1 and negative first -1 diffraction orders. The plurality of diffraction orders may be interfered or compared with each other and/or with one or more reference signals in the PIC at the detector and/or before being measured by the detector. Captured radiation may be interfered in the PIC before being directed to a detector. The interference of captured radiation, or more generally, a combination of radiation to be measured, may for example take place inside a multi-mode interferometer MMI which may be implemented in the waveguide patterns in the PIC. Other types of designs and waveguide structures to perform a combination of radiation (e.g. interferometry) exist and may be suitable to be implemented in the PIC.

Directing (interfered) radiation to a detector may comprise coupling the radiation into a fibre that guides the radiation to the detector. The detector may for example be a photodiode. The fibre may be a single mode fibre. The radiation output by the fibre may contain information that was present in the interference pattern, which may comprise intensity and/or phase information of the radiation. In some alternative examples, an intensity distribution of an interference pattern may be captured by a detector directly, without being guided to a waveguide or a fibre.

The PIC may be configured to receive radiation from the PCSEL via at least one input coupler. The PIC may direct at least some of the radiation to the substrate via at least one output coupler of the PIC. The PIC may receive the radiation from the PCSEL via at least one input (grating) coupler. The PIC may comprise one or more (e.g. a plurality of) waveguides to direct at least some of the received radiation to at least one output coupler, e.g. grating output coupler or referred to as output grating coupler or grating out-coupler, for coupler radiation out of the PIC to be directed at the substrate of interest.

A metamaterial layer (e.g. a metasurface) may be positioned at an output of the PCSEL for shaping the radiation beam output by the PCSEL. Shaping the radiation output by the PCSEL may comprise shaping the wavefront of the radiation output by the PCSEL. The wavefront may be shaped to make the beam suitable for coupling into a waveguide of the PIC via the input coupler. The specific requirements of such a wavefront may depend on the radiation beam and the characteristics of the input coupler and the waveguide shape.

The PIC may comprise one or more input couplers and/or one or more output couplers located on a front surface of the PIC. The front surface of a PIC may be a surface on the PIC facing towards a substrate to be measured. The PIC may comprise one or more output couplers for coupling radiation out of the PIC to direct it towards the substrate. In some instances, a single output coupler may be used to direct a single radiation beam from the PIC to the substrate. In some other instances, one or more, e.g. a plurality of, output couplers may be used to direct multiple radiation beams from the PIC to the substrate. When a plurality of output couplers are used, the plurality of radiation beams may be directed towards the substrate at different angles of incidence. The plurality of radiation beams may overlap at the substrate and may interact with each other at the substrate to form structured radiation, such as interference patterns.

The PIC may comprise one or more input couplers for capturing radiation that has interacted with the substrate. In some instances, a single input coupler may be used to capture a single radiation beam from the substrate. This may for example comprise a single diffracted radiation order, or a (single) reflected radiation beam, or a (single) scattered radiation beam. In some other aspects, one or more, e.g. a plurality of, input couplers may be used to capture one or more, e.g. a plurality of, radiation beams. The plurality of radiation beams may be scattered, reflected, and/or diffracted by the substrate at different angles, therefore having different positions of incidence on the PIC, to be captured by different in-couplers at different positions on a front surface of the PIC.

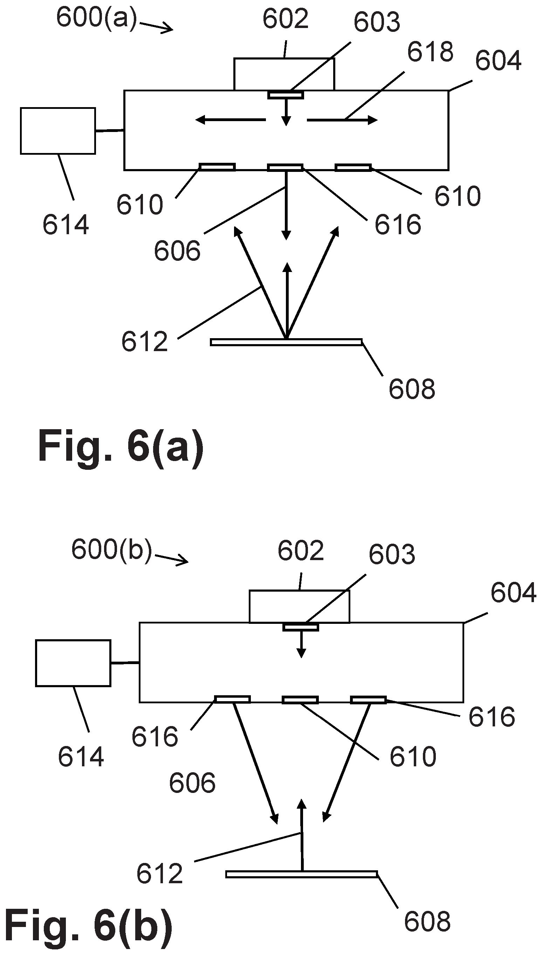

Figure 6(a) depicts a schematic representation of a first embodiment of a metrology assembly 600(a) having features in line with the metrology assembly of Figure 5. The first embodiment comprises a PCSEL 602 bonded directly to a back surface of a PIC 604. The assembly 600(a) may be configured to provide a reference signal inside the PIC to enable an interferometry measurement. The radiation of the PCSEL may be coupled into the PIC through a (grating) in-coupler 603. While in the depiction of Figure 6, the PCSEL may be positioned in the center of a back surface of the PIC. However, this is not a requirement, and the PCSEL may be positioned anywhere on the PIC. If the metrology assembly uses one or more, e.g. a plurality of, reference branches 618, e.g. for an interferometric metrology application, the reference branches may have the same length. This may require additional design considerations, especially when the PCSEL is not located in the center of the PIC backs surface. The PIC may use one or more waveguides, e.g. a plurality of waveguides, and the waveguides may be inscribed into the material of the PIC. The waveguides may receive and guide radiation from the PCSEL towards one or more out-couplers 616, and optionally to one or more reference branches (the one or more waveguides being referred to as one or more reference waveguides). The radiation 606 that is coupled out of the PIC by the one or more out-couplers may be directed to a substrate 608 to illuminate the substrate.

The radiation 606 coupled out of the PIC may illuminate one or more structures of interest on the substrate. The structures of interest may be one or more diffraction gratings. Radiation 612 may be diffracted by (and/or otherwise interact with) the substrate. One or more diffracted radiation order(s) may be captured by the PIC. The captured diffracted orders may comprise at least one non-zeroth diffraction order (e.g. a positive first +1 and/or a negative first -1 diffraction order). Diffracted radiation may be captured by the PIC by being incident on one or more in-couplers 610 of the PIC, which may be grating in-couplers configured to couple radiation into the PIC. The captured radiation may be guided through one or more waveguides in the PIC to a detector 614, the one or more waveguides being referred to as one or more detection waveguides. The in-couplers may detect either positive and negative first to nth diffraction orders for a single wavelength, or positive and negative diffraction orders of different wavelengths, or the combination of both different diffraction orders and wavelengths.

The radiation captured by the PIC may be interfered with other radiation captured from the substrate and/or with radiation from the one or more reference branches to generate interference patterns. The presence of one or more reference branches is not essential for the creation of interference patterns, and radiation captured from the substrate by a plurality of input couplers may be combined with each other to form an interference pattern. The interference pattern may be generated directly on the detector or may be generated inside the PIC and guided to the detector. An intensity distribution of the interference pattern(s) may be measured and used to extract intensity and phase information, which may be used to determine a parameter of interest. In some embodiments, the metrology assembly and the substrate may be moved relative to each other to capture and measure a position-dependent signal for determining the parameter. The movement of the metrology assembly relative to the substrate may comprise a scanning movement along one or more linear directions. The parameter may be of the substrate, which may include a parameter of the substrate itself or associated with the substrate, e.g. its environment.

An advantage of the embodiment of Figure 6(a) may be that it allows both phase and intensity information of the radiation pattern to be determined, due to the formation of or provision of an interference pattern at the detector. This allows for information to be determined that would not be available in metrology setups that only measure intensity without comprising phase information. An advantage of bonding a PCSEL to a back surface of the PIC may be that this provides more space around the PCSEL, for example for wiring or cooling.

Figure 6(b) depicts a schematic representation of a second embodiment of a metrology assembly 600(b) having features in line with the metrology assembly of Figure 5. The second embodiment comprises a PCSEL 602 bonded directly to a back surface of a PIC 604. The second embodiment may be configured to provide multiple beams of radiation simultaneously at the substrate to be measured. The second embodiment depicts a configuration where the PCSEL 602 bonded to the back surface of the PIC 604. The front surface of the PIC may comprise a plurality of out-couplers to enable illumination of a target on a substrate 608 by multiple radiation beams at different angles of incidence simultaneously. The radiation from the PCSEL may be coupled into the PIC using an in-coupler 603. Subsequently, the radiation may be guided in the PIC, e.g. through one or more waveguides, to one or more, e.g. a plurality of, out-couplers 616. The out-couplers, which may be located at different positions on the front surface of the PIC, may couple radiation out of the PIC. Each out-coupler may direct a radiation beam towards the substrate 608 at a different angle from each other.

The different radiation beams may interact at the substrate 608, for example to form a structured radiation pattern on the substrate. The resulting radiation pattern may interact with the feature of interest on the substrate 608. Radiation that has interacted with the substrate may be scattered, reflected, and/or diffracted towards one or more in-couplers on the PIC. The in-coupler(s) may capture part of the radiation that has interacted with the substrate and the PIC may guide captured radiation towards the detector 614, where characteristics and properties of the captured radiation may be measured for determining the parameter of interest.

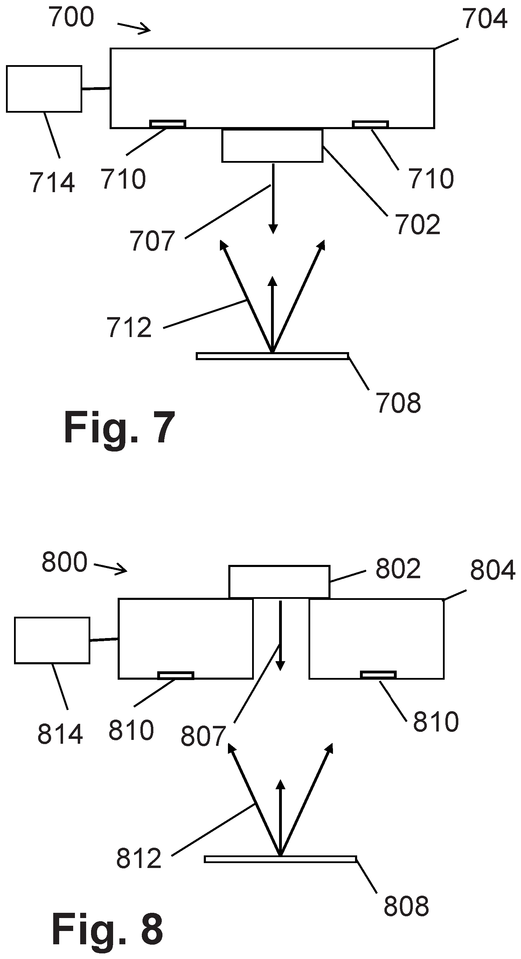

Figure 7 depicts a schematic representation of a metrology assembly 700 for measuring a parameter of a substrate 708. The metrology assembly comprises a PCSEL 702 and a PIC 704. The PCSEL may be directly attached to a front surface of the PIC. A metamaterial may be placed between an output of the PCSEL and the substrate, or the PCSEL may be a modulated PCSEL M-PCSEL. The PCSEL is configured to direct at least some of the radiation 707 output by the source to the substrate 708. The PIC has at least one input coupler 710 configured to capture at least some radiation 712 originating from the PCSEL that has interacted with the substrate. The metrology assembly further comprises a detector configured to receive at least some of the captured radiation from the PIC for measuring the parameter. Advantages of placing a PCSEL directly onto a front surface of the PIC may include reduced or no interaction (and therefore reduced losses) of the radiation with the PIC before it reaches the substrate, and a possibility of improved illumination and beam shaping control (e.g. due to the shaping being possible directly from the output of the PCSEL, e.g. with a metamaterial and/or using a M-PCSEL).

The assembly of Figure 7 has a PCSEL directly arranged and/or integrated onto a front surface of the PIC. The radiation 707 output by the PCSEL for a metrology assembly according to Figure 7 may be directed towards the substrate without first interacting with the PIC. This radiation may illuminate a substrate of interest 708, and radiation that has interacted with the substrate may be scattered, reflected, and/or diffracted. At least some of the radiation that has interacted with the substrate may be captured by one or more in-couplers 710 of the PIC. The PIC may guide this radiation e.g. via one or more waveguides to a detector 714 for measuring one or more properties of the radiation and determining a parameter of interest.

The PCSEL 702 may provide focused light at the substrate 708. To achieve this, the PCSEL may comprise a metamaterial, such as a metasurface. Alternatively or additionally, the PCSEL may be a M-PCSEL for shaping the wavefront of the radiation output by the beam. The shaping of the wavefront may render the radiation suitable for illuminating the substrate.

Figure 8 depicts a schematic representation of an embodiment of a metrology assembly 800 having features in line with the metrology assembly of Figure 5. In the configuration depicted in Figure 8, the PCSEL 802 may be bonded onto a back surface of the PIC 804, while an opening, which may be referred to as a hole, a gap, or an aperture, may be present in the PIC. The opening may be at or close to the center of the PIC, but this is not essential. Direct contact may be made between metal contact pads on the PCSEL and metal traces on the back surface of the PIC. This may have benefits in the fabrication process of the metrology assembly. The opening may reach from the back surface of the PIC to the front surface of the PIC. The opening may be large enough for radiation 807 from the PCSEL 802 to pass through the hole be directed towards a substrate 808.

Radiation from the PCSEL 802 may reach the substrate 808 without interacting with the PIC 804, and while the PCSEL is directly attached to the back surface of the PIC. The opening may be a hole in a PIC that is an integral, monolithic, or unitary material structure. Alternatively, the opening may be a gap formed by two or more separate portions of PIC material. An advantage of this setup is that the placement of the PCSEL 802 is on a back surface of the PIC where it may be more convenient, as it is not in the way of other components or radiation parts. Simultaneously, an advantage of having the radiation go directly from the PCSEL 802 to the substrate may mean that there are no losses or aberrations associated with a radiation 807 moving through the PIC 804.

At the substrate, radiation 812 may be scattered, reflected, and/or diffracted by the substrate (e.g. by one or more metrology target on the substrate). A front surface of the PIC may comprise one or more input couplers 810 configured to capture some of the radiation that has interacted with the substrate. The PIC may guide the captured radiation from the substrate to a detector 814. The guiding of radiation through the PIC to a detector may be the same as for other embodiments described throughout this specification. The opening in the PIC as described herein may either be an aperture that is fully enclosed by parts of the PIC, that is to say, the PIC is comprised of a single part. In other embodiments, the opening and the PIC may be a gap that divides the PIC into two fully separate portions. The PCSEL 802 may comprise a metamaterial such as a meta grating, for shaping the radiation output by the PCSEL. The PCSEL 802 may be an M-PCSEL for shaping the radiation output by the PCSEL. The resulting radiation output by the PCSEL may be shaped such that it is suitable for illuminating the substrate for metrology. The radiation beam shaping may for example include providing focused radiation at the substrate. A standard PCSEL delivering a single-mode emission profile may have natural divergence, It may not be possible to deliver a collimated beam directly from the substrate. However, as discussed above, PCSELs that have a very small divergence angle can be provided, meaning the output radiation may have a beam shape that approximates an (almost) collimated beam over short propagation lengths and distances. A M-PCSEL, or a PCSEL with metamaterial may both provide a radiation beam that is collimated, focusing, diverging, or diffracted.

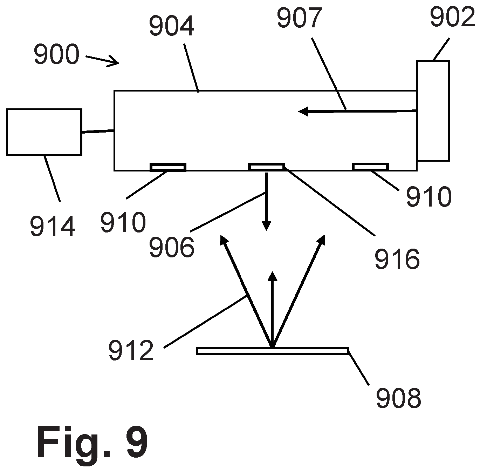

Figure 9 depicts a schematic representation of a metrology assembly 900 for measuring a parameter of a substrate. The metrology assembly comprises a PCSEL 902 configured to output radiation 907. The metrology assembly further comprises a PIC 904. The PCSEL 902 is directly attached to a side surface of the PIC 904. The PIC is configured to receive radiation 907 from the PCSEL 902. The radiation may for example be coupled into the PIC via an input coupler. The PIC 904 may direct at least some of the radiation 906 to the substrate 908 via at least one output coupler 916. The radiation may be scattered, reflected, and/or diffracted by the substrate 908. The PIC has at least one input coupler 910 for capturing some of the radiation 912 that has interacted with the substrate 908. The PIC 904 may have any of the characteristics of a PIC as described throughout this disclosure, such as those described in relation to Figures 5 and 6. The PIC may direct at least some of the captured radiation to a detector 914 for measuring the parameter.

Coupling radiation from the PCSEL to the PIC via the side surface may also be referred to as coupling in radiation from a facet-side. Coupling facet-side may require the PCSEL to generate a small focus spot to ensure coupling into a waveguide in the PIC. The waveguide may have a size of the order of micrometers. Facet-side coupling may be challenging due to the requirement on the radiation beam and the alignment of the PCSEL radiation source perpendicular to the plane of the PIC. The high quality of the beam output by a PCSEL may make it more suitable compared to other types of radiation sources to generate the beam size and shape required for facet-side coupling. The PCSEL may use a metamaterial (e.g. a focusing meta lens) or be a M-PCSEL in order to shape the beam to be coupled into the PIC. Alternatively or additionally, one or more of a surface lens, a spot-size converter, or a PIC edge coupler may be used to couple radiation from the PIC directly into a waveguide of the PIC.

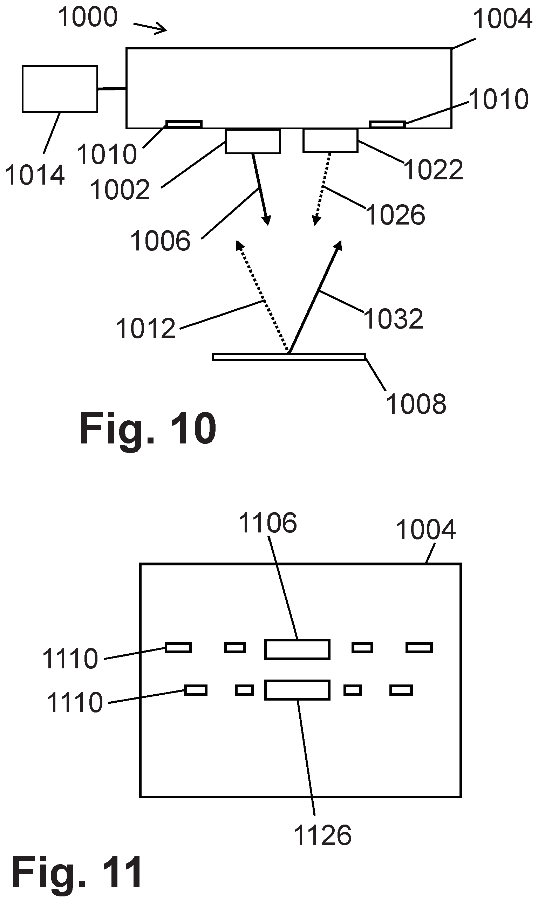

The metrology assemblies described herein may receive a single wavelength of radiation from the PCSEL. However, in some embodiments, multiple wavelengths may be provided to the PIC. This may be achieved for example by having a plurality of PCSELs directly attached to the PIC. Figure 10 depicts a schematic representation of a metrology assembly 1000, comprising a PIC 1004, and a plurality of PCSELs. While Figure 10 depicts two PCSELs 1002 and 1022, the metrology assembly may also comprise three, four, or more PCSELs. In one embodiment, Each of the plurality of PCSELs may be configured to output a different wavelength of radiation 1006, 1026. Each PCSEL may be configured to output a single wavelength of radiation. The metrology assembly may have any of the properties of any of the metrology assemblies described herein. This may include a combination of properties from different embodiments described herein, as long as this combination is not impossible. The PIC may comprise at least one input coupler 1010 per PCSEL for capturing at least some radiation 1012, 1032 of each wavelength that has interacted with the substrate 1008. Captured radiation may be guided by the PIC to a detector 1014.

Alternatively or additionally to providing radiation of different wavelengths, multiple PCSELS may be added to a metrology assembly to provide radiation having different polarization states, and/or different wavefront shapes (e.g. different direction, different angle of incidence on the substrate, different focal depths, different beam diameter, etc.)

In Figure 10, the two PCSELs may be directly attached to a front surface of the PIC. Configurations where the PCSELs are attached to a back surface and/or side surface of the PIC are also possible. The two PCSELs are configured to output two different wavelength of radiation and illuminate the target under a different angle. The PCSELs may be designed to omit radiation at an angle, for example to avoid the use of additional optics to redirect the emitted radiation towards the target at the desired angle. The angle may for example be different in the Y direction, which may be one of the directions in the plane of the PIC. The substrate 1008 may scatter, reflect, and/or diffract radiation 1012 and 1032 from the two PCSELs.

In an example configuration, the substrate may comprise one or more metrology targets configured to diffract radiation in the X direction, which may be a direction perpendicular to the Y direction and in the plane of the PIC. The plane of the PIC may be the same as the plane of the substrate. As a result of this difference and direction between angle of incidence and angle of the fraction separate detection of the different wavelengths may be possible.

Figure 11 depicts a schematic representation of a front surface of a PIC 1104 comprising 2 PCSELs 1106 and 1126 directly attached to it, for example as depicted in Figure 10. The front surface of the PIC may also comprise one or more input couplers 1110 for each PCSEL, for example to capture diffracted radiation orders from a substrate. In Figure 11, four input couplers are shown per PCSEL, for example for capturing positive and negative first and second (or third) -1, +1, -2 (or -3), +2 (or +3) diffraction orders. The position of the input couplers may be different for each PCSEL to accommodate the diffraction angles of the different wavelengths.

In one example configuration, the metrology assemblies depicted in Figures 5 - 11 may be provided in an alignment sensor, in which an alignment target may be irradiated and radiation that has interacted with the target is measured by the detector. Alignment may be measured in two dimensions, e.g. X- and Y-directions in the plane of the substrate, which may also be referred to as horizontal and vertical directions, and which may be perpendicular to each other. Alignment targets may include diffraction gratings, may be rectangular in shape, and may have a dimensions in a range of 1s - 10s of µm.

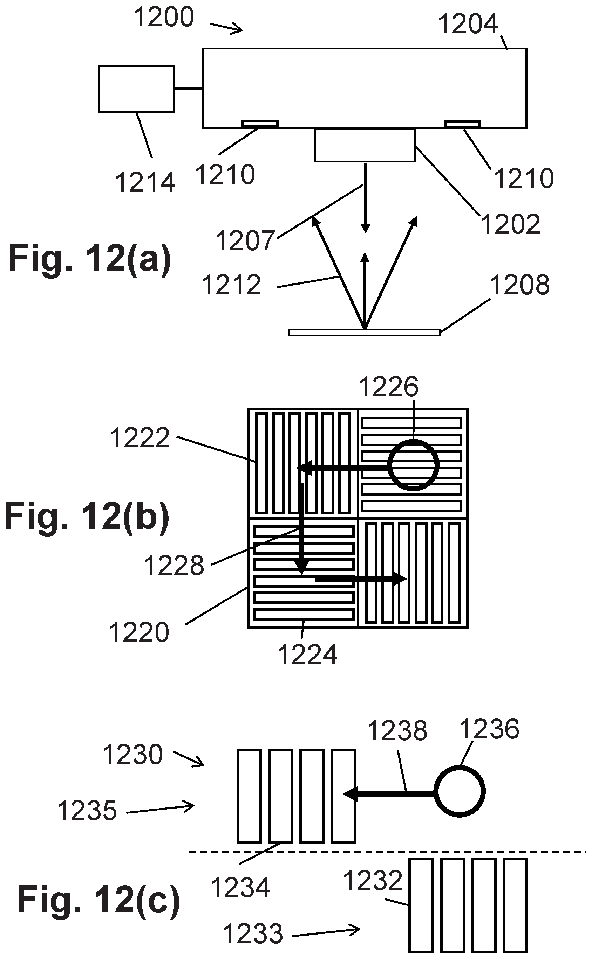

Figure 12(a) depicts a schematic representation of an embodiment of a metrology assembly 1200 for measuring a parameter on a substrate 1208. The metrology assembly comprises a PCSEL 1202 and a PIC 1204. The PCSEL may be directly attached to a front surface of the PIC. The PCSEL may be a M-PCSEL. The PCSEL may comprise a metamaterial for shaping the radiation beam 1207 output by the PCSEL. The PCSEL is configured to direct at least some of the radiation 1207 output by the PCSEL to a metrology target 1220, 1230 substrate 1208. The metrology target may diffracted radiation 1212 may be captured by at least one input coupler 1210 and coupled into the PIC. The PIC may direct the captured diffracted radiation to a detector 1214. The captured radiation may be interacted with a reference beam or other captured radiation to form an interference pattern, before being measured at the detector. The measured radiation may be used to determine a parameter of the substrate.

While the metrology assembly 1200 depicted in Figure 12(a) may be suitable for measuring a range of different parameters such as alignment, levelling, dose, focus, etc., Figure 12 will be described in more detail for an example application wherein the parameter to be measured is overlay. In order to measure overlay of a substrate, the substrate may comprise a metrology target. Figure 12(b) depicts a schematic representation over an overlay target 1220 comprising four different diffraction gratings located in four quadrants of the area of the target. The target may comprise diffraction gratings in perpendicular directions, which may be referred to as a grating in an X-direction 1222 and a grating in a Y-direction 1224. The two directions may lie in the plane of the substrate. The target may be centrosymmetric. Diffraction gratings having the same orientation may be positioned in diagonally opposed locations of the quadrant. The target may comprise (partly) overlapping quadrants of gratings in two different layers (not depicted). The two different layers may be referred to as a top layer and a bottom layer, wherein the top layer may be closest to a surface of the substrate on which the radiation is incident.

An underfilled radiation beam 1226 may illuminate each of the four diffraction gratings separately, e.g. by being moved in a scanning motion 1228 across the metrology target on the substrate. The scanning movement may be caused by the position of the radiation source moving relative to the position of the substrate, and may be achieved by either moving the source or the substrate or both. The measurement depicted in Figure 12(b) may involve the PCSEL 1202 focusing an underfilled spot 1226 on to the metrology target 1220. Subsequently, diffraction orders may be directly captured by two grating input couplers 1210. The relative intensity between the two diffraction orders may be used to compute the overlay of the target.

Figure 12(c) depicts another example metrology target, which may be referred to as a phase aware target. The phase aware target of Figure 12(c) may comprise a first diffraction grating 1232 in a bottom layer 1233, and a second diffraction grating 1234 in a top layer 1235. The two diffraction gratings may be (partly) non-overlapping in the plane of the substrate. An underfilled radiation spot 1236 may be scanned 1238 across the diffracting gratings. Diffracted radiation from both diffraction gratings (e.g. positive first and negative first diffracted radiation orders) may be captured by input couplers 1210 of the PIC 1204. Specifically, signals from the positive first and negative first order may be interfered inside the PIC, for example using an MMI. The interference patterns may be guided to a detector and measured to determine overlay of the top and bottom layers of the substrate.

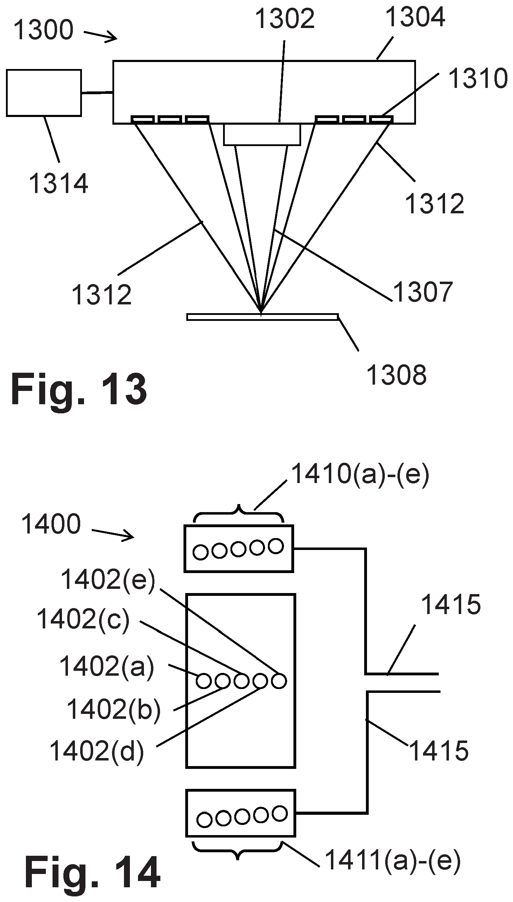

Figure 13 depicts a schematic representation of a metrology assembly 1300 comprising a single wavelength PCSEL radiation source 1302 attached to a front surface of a PIC 1304. The PCSEL 1302 may output radiation 1307 having a larger illumination numerical aperture NA, e.g. > 0.01, >0.03 or >0.1. The larger NA of the radiation output by the PCSEL may be achieved for example by increasing the lateral dimensions of the PCSEL. The larger NA radiation may illuminate a target (e.g. an overlay target) on the substrate 1308. A potential advantage of the larger illumination numerical aperture may be that it can enable detection of diffraction orders 1312 with angular resolution. In order to detect diffraction orders with angular resolution, a grid of input couplers 1310 may be used. This grid of input couplers may be instead of a single input coupler depicted in previous embodiments of metrology assemblies. The input couplers may be grating couplers. The grid of input couplers 1310 may be used to provide angular resolution. Grating couplers may be positioned in a grid having a separation between them of the order of tens of micrometers (1e¹ µm). The radiation from the grid of input couplers may be provided to a detector for determining a parameter of interest of the substrate. However, it should be noted that if there are too many signal channels (e.g. > 50 signal channels), signal processing may become too extensive to be feasible for the metrology assembly. As a result, the number of grating input couplers may be limited, e.g. ≤ 49, ≤ 25, or ≤ 16. The captured grid of angularly resolved radiation may be interfered, for example between the positive first and negative first orders. This interference pattern may be used to obtain phase information of the overlay target.

The metrology assemblies described herein make use of a PCSEL radiation source. A standard PCSEL is configured to output a single wavelength of radiation. However, it is also possible to consider metrology assemblies that have a multi-wavelength (simultaneous) measurement approach. This may for example be achieved by integrating multiple PCSELs onto the PIC of a metrology assembly. Figure 10 depicts an example configuration with two PCSELs. However, two PCSELs is not an upper limit, and more PCSELs can be included on a PIC. Figure 14 depicts a schematic representation 1400 of a plurality of PCSELs being used in a metrology assembly setup. In this example configuration, 5 PCSELS 1402(a)-(e) outputting a different (single) wavelength each may be provided attached to a PIC of a metrology assembly as described herein. The configuration using a plurality of PCSELs may be provided in combination with any of the metrology assemblies described herein. Each of the radiation wavelengths from the different PCSELs may be directed to the substrate to illuminate a metrology target that diffracts at least some of the incident radiation.

A plurality of input couplers may be positioned side-by-side on the PIC, such that they may capture the diffraction orders of the multiple different wavelengths. The side-by-side positioning of the input couplers may be set on the PIC to correspond to the side-by-side positioning of the PCSELs on the PIC. Due to the different wavelengths, diffraction angles of the different wavelengths will be different, meaning the incident position of the radiation of different wavelengths on the PIC will be different. As a result, each input coupler position may also be set to such that it takes into account the different diffraction angles of the different wavelengths. An advantage of using grating input couplers in this side-by-side configuration, is that grating couplers are sensitive to input angle and wavelength. Therefore, the input couplers for the different wavelengths may act as a filter and help avoid cross-talk between the radiation originating from the different PCSELs.

In the example configuration of Figure 14, two sets of five different input couplers may be positioned to capture five positive first diffraction orders 1410(a)-(e) and the five negative first diffraction orders 1411(a)-(e), respectively. Once captured, the radiation may optionally be interfered with reference beams and/or other captured radiation (e.g. positive first and negative first order diffracted radiation of the same wavelength). The radiation may then be directed, e.g. via one or more detection waveguides 1415, to a detector, where the radiation from the different wavelengths can be measured and the parameter of interest can be determined. The one or more detection waveguides may be the same as the waveguide or the reference waveguide described herein.

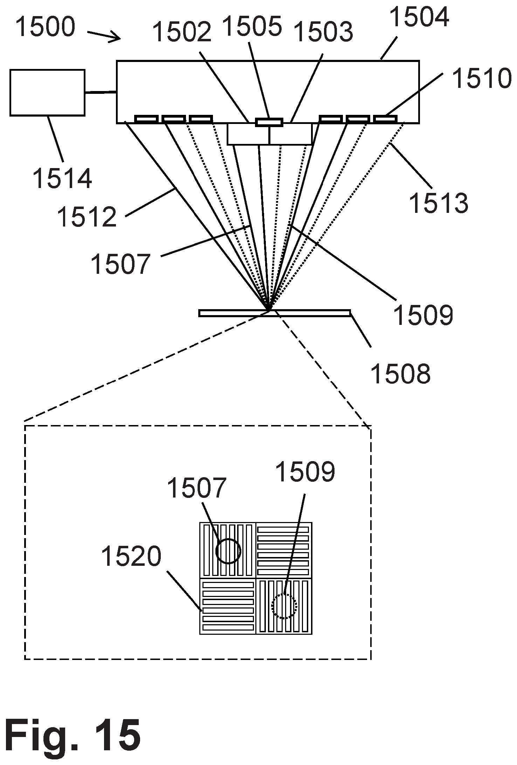

Figure 15 depicts another example embodiment of a metrology assembly 1500 comprising multiple PCSELs. Figure 15 depicts a configuration for simultaneously illuminating a metrology target on a substrate in an underfilled illumination protocol. The metrology target may for example be a diffraction-based overlay target 150. Two (or more) PCSELs 1502 1503 may be provided on PIC 1504. The PCSELs may be made coherent with respect to each other, for example by using a coherence coupler 1505 connecting the PCSELs. The coherence coupler 1505 may for example comprise a waveguiding structure to ensure that the PCSELs emit with the same mode. Fine alignment of the focus position of the PCSEL may be achieved for example through the modification of the injection current (see e.g. Si, Jiahao, et al. "Active beam steering enabled by photonic crystal surface emitting laser." 2023 Opto-Electronics and Communications Conference (OECC). IEEE, 2023.)

In an example implementation depicted in Figure 15, two separate PCSELs may be configured to underfill irradiate different diffracting gratings (or overlapping or partly overlapping diffraction gratings in different layers of the substrate 1508) with two illumination beams 1507 1509 focused in the same plane. The different pads of (overlapping) diffraction gratings may for example be two diagonally opposed pads of a metrology target as described in relation to Figure 12(b). The signals from the separate diffraction gratings may be captured by separate grating input couplers 1510. For example, radiation from a first PCSEL 1507 may have positive first +1 and negative first -1 radiation orders 1512 captured by different input couplers. Radiation from the second PCSEL 1509 may have positive first +1 and negative first -1 radiation orders 1513 captured by still different input couplers. The captured radiation may be interfered with each other and/or a reference signal and directed to a detector 1514 for measuring a parameter of the substrate, such as overlay.

The metrology assemblies described herein may capture radiation from a substrate to determine a parameter associated with the substrate. The substrate may be a lithographically patterned substrate. The parameter to be measured may be a parameter associated with the lithographic patterning process and/or resulting pattern. The metrology assembly may be configured to determine more than one parameter. The parameter may for example be alignment or overlay. The parameter may alternatively or additionally comprise dose, focus, levelling, pressure, temperature, etc.

A PCSEL forming part of a metrology assembly may output continuous wave CW radiation or pulsed radiation. An upper limit to the power of the PCSEL may be set by a damage threshold of the materials that interact with the radiation. The lower limit of the radiation power may be set by the signal-to-noise ratio of the resulting metrology system and/or the lasing threshold of the PCSEL. The PCSEL may output single wavelength radiation, or substantially single wavelength radiation, or narrowband radiation. In some instances, the PCSEL may be configured to output radiation having a wavelength in a range of 250 nm to 1550 nm, or 400 nm to 900 nm. The substrate may be a bonded substrate. The PCSEL and metrology assembly may use any wavelength in the telecom, near-infrared, visible, and/or near-UV parts of the electromagnetic spectrum.

A CW PCSEL may emit radiation with an average power for example in a range of 80 µW to 320 mW, or for example in a range of 50 µW to 500 mW. These ranges are provided as an example only, and other average power ranges may be possible within operating limits and requirements of specific setups. A maximum power for a CW PCSEL may be set by a damage threshold for the materials used in the metrology assembly, including the substrate, the PCSEL, and the PIC. In an example, the CW damage threshold for a material may be 1x10⁸W/m². The amount of power provided on a surface by a PCSEL will also depend on the size of the focus spot on the surface of the material. For example, for a focus spot on a surface having a radius of 32 µm, a CW power of 320 mW would be required to reach the damage threshold of 1x10⁸W/m². In another example, a focus spot on a surface having a radius of 16 µm may have a PCSEL with a CW power of 80 mW to reach a damage threshold of 1x10⁸W/m². In yet another example, for a focus spot on a surface having a radius of 0.5 µm, a CW power of 80 µW would be required to reach the damage threshold of 1x10⁸W/m².

A pulsed PCSEL may emit radiation with a peak power in a range of 80mW to 320W, or for example in a range of 50 mW to 500 W. These ranges are provided as an example only, and other peak power ranges may be possible within operating limits and requirements of specific setups. The average power a pulsed PCSEL may for example be in a range of 1 mW to 10 W. A maximum power for a pulsed PCSEL may be set by a damage threshold for the materials used in the metrology assembly, including the substrate, the PCSEL, and the PIC. The pulsed damage threshold for a material may be a peak power of 1x10¹¹W/m². The amount of power provided on a surface by a PCSEL will also depend on the size of the focus spot on the surface of the material. For example, for a focus spot on a surface having a radius of 32 µm, a pulsed peak power of 320 W would be required to reach a pulsed damage threshold of 1x10¹¹W/m². In another example, a focus spot on a surface having a radius of 16 µm may have a PCSEL with a CW power of 80 W to reach a pulsed damage threshold of 1x10¹¹W/m². In yet another example, for a focus spot on a surface having a radius of 0.5 µm, a CW power of 80 mW would be required to reach the damage threshold of 1x10¹¹W/m².

A PIC as described herein may comprise one or more materials, which may include silicon-on-insulator SOI (e.g. silicon Si, silicon dioxide SiO₂), indium phosphide InP, silicon nitride SiN (silicon nitride Si₃N₄, silicon dioxide, silicon), lithium niobate on insulator LNOI (e.g. lithium niobate LiNbO₃, silicon dioxide, silicon), indium gallium arsenide phosphide (InGaAsP), aluminium indium gallium arsenide (AlInGaAs), aluminium indium arsenide (AlInAs), indium gallium arsenide (InGaAs), aluminium oxide (Al₂O₃), aluminium nitride (AlN). The PCSEL may be directly attached to a front surface or a back surface of a PIC using at least one of flip-chip bonding, micro transfer printing, soldering, thermocompression, adhesive bonding or any other suitable direct attachment means used in the art. More generally, the PCSEL and the PIC may be attached using a hybrid integration method. Directly attaching the PCSEL and PIC may involve providing electrical connections between the two dies. This may for example be achieved using solder bumps deposited on one or both of the connecting surfaces of the PCSEL and PIC. Flip-chip bonding may refer to bonding the front surface of a first semiconductor substrate to the front surface of another semiconductor substrate, by flipping one substrate such that the front surfaces of the two substrates face each other.

The PIC may comprise one or more input couplers for coupling radiation from outside the PIC into the PIC. The input couplers may be grating input couplers. The PIC may comprise one or more output couplers for coupling radiation from inside the PIC to outside the PIC. The output couplers may be grating output couplers. Input couplers may be used to couple radiation from the PCSEL into the PIC. Input couplers may be used to couple radiation from the substrate to be measuring into the PIC. Output couplers may be used to couple radiation from inside the PIC to outside the PIC, e.g. to the substrate to be measured.

Alternatively or additionally, the PCSEL mention in any of the embodiments may be a M-PCSEL, configured to comprise wavefront shaping features inside the PCSEL device.

The metrology assembly may form part of an exposure apparatus, for example an assessment apparatus, for example a metrology apparatus or an inspection apparatus. The metrology apparatus may be a wafer alignment tool, an overlay metrology tool, or an optical encoder tool for measuring the position of a stage in a semiconductor patterning device such as a wafer stage of a reticle stage. The metrology assembly may form part of a semiconductor processing apparatus, such as a lithography apparatus. The metrology assembly and/or any apparatus comprising a metrology assembly may form part of a litho cell.

Further embodiments are disclosed in the subsequent numbered clauses:
1. A metrology assembly for measuring a parameter of a substrate, the metrology assembly comprising:
   a photonic crystal surface emitting laser PCSEL configured to output radiation;
   a photonic integrated circuit PIC;
   wherein:
      the PCSEL is directly attached to a back surface of the PIC;
      the metrology assembly is configured to direct the radiation from the PCSEL to the substrate; and
      the PIC has at least one input coupler configured to capture at least some of the radiation after it has interacted with the substrate; and
   a detector configured to receive at least some of the captured radiation from the PIC for measuring the parameter.
2. A metrology assembly according to clause 1, wherein the PIC is configured to receive the radiation from the PCSEL and direct at least some of the radiation to the substrate via at least one output coupler of the PIC.
3. A metrology assembly according to clause 2, wherein the PIC comprises a plurality of waveguides configured to direct at least some of the radiation received from the PCSEL to the at least one output coupler of the PIC configured to direct the radiation to the substrate.
4. A metrology assembly according to clause 2 or 3, wherein the PIC comprises a plurality of output couplers.
5. A metrology assembly according to clause 4, wherein the plurality of output couplers are configured to direct radiation having different angles of incidence onto the substrate.
6. A metrology assembly according to any of clause 2- 5, wherein the PIC has an input grating coupler configured to receive radiation from the PCSEL.
7. A metrology assembly according to any of clauses 1 - 6, wherein a metamaterial is positioned between an output of the PCSEL and the PIC, and wherein the metamaterial is configured to shape the wavefront of the radiation output by the PCSEL to couple it into the PIC.
8. A metrology assembly according to any of clauses 1 - 7, wherein the PCSEL is a modulated photonic crystal surface emitting laser M-PCSEL.
9. A metrology assembly according to any of clauses 2 - 8, wherein the PIC comprises a plurality of input couplers configured to capture radiation from the substrate.
10. A metrology assembly according to any of clauses 1 - 9, wherein the PIC comprises one or more reference waveguides configured to guide a portion of the radiation from the PCSEL to one or more reference branches.
11. A metrology assembly according to clause 10, wherein the PIC is configured to interfere the captured radiation from the substrate with the radiation from the one or more reference branches to form an interference pattern on the detector.
12. A metrology assembly according to clause 11, wherein the detector is configured to extract at least one of phase information and amplitude information from the interference pattern for determining the parameter.
13. A metrology assembly according to clause 1, wherein a PIC comprises an opening, wherein the PCSEL is directly attached to the back surface the PIC, and wherein the PCSEL is configured to output radiation through the opening for directing to the substrate.
14. A metrology assembly for measuring a parameter of a substrate, the metrology assembly comprising:
   a photonic crystal surface emitting laser PCSEL configured to output radiation;
   a photonic integrated circuit PIC;
   wherein:
      the PCSEL is directly attached to a front surface of the PIC;
      the PCSEL is configured to direct at least some of the radiation to the substrate;
      the PCSEL is a modulated-photonic crystal surface emitting laser M-PCSEL and/or a metamaterial is placed between an output of the PCSEL and the substrate; and
      the PIC has at least one input coupler configured to capture radiation that has interacted with the substrate; and
      a detector configured to receive at least some of the captured radiation from the PIC for measuring the parameter.
15. A metrology assembly according to clause 14, wherein the PCSEL has a metamaterial placed between an output of the PCSEL and the substrate, wherein the metamaterial is a metasurface layer configured to direct radiation from the PCSEL to the substrate.
16. A metrology assembly according to clause 14, wherein the PCSEL is a modulated PCSEL M-PCSEL configured to output radiation with a non-flat wavefront.
17. A metrology assembly for measuring a parameter of a substrate, the metrology assembly comprising:
   a photonic crystal surface emitting laser PCSEL configured to output radiation;
   a photonic integrated circuit PIC;
   wherein:
      the PCSEL is directly attached to a side surface of the PIC;
      the PIC is configured to receive radiation from the PCSEL and direct at least some of the radiation to the substrate via at least one output coupler of the PIC; and
      the PIC has at least one input coupler configured to capture radiation that has interacted with the substrate; and
      a detector configured to receive at least some of the captured radiation from the PIC for measuring the parameter.
18. A metrology assembly according to any of clauses 1 - 17, wherein the metrology assembly comprises a plurality of PCSELs.
19. A metrology assembly according to clause 18, wherein at least one PCSEL of the plurality of PCSELs outputs radiation that has a different wavelength to at least one other PCSEL of the plurality of PCSELs.
20. A metrology assembly according to any of clauses 18 - 19, wherein the plurality of PCSELs are located side by side on a front surface of the PIC.
21. A metrology assembly according to any of the preceding clauses, wherein the metrology assembly is configured to detect diffraction orders with angular resolution .
22. A metrology assembly according to clause 21, wherein the PIC comprises a grid of input couplers.
23. A metrology assembly according to any of the preceding clauses, wherein the parameter is substrate alignment.
24. A metrology assembly according to any of clauses 1 - 22, wherein the parameter is overlay.
25. A metrology assembly according to clause 24, wherein the substrate comprises a diffraction-based metrology target or a phase aware target.
26. A metrology assembly according to any of the preceding clauses, wherein the input coupler is a grating coupler.
27. A metrology assembly according to any of the preceding clauses, wherein the PIC comprises one or more detection waveguides configured to direct at least some of the captured radiation to the detector.
28. A metrology assembly according to any of the preceding clauses, wherein the PCSEL is configured to output continuous wave radiation.
29. A metrology assembly according to clause 28, wherein the continuous wave radiation has an average power in a range of 80 µW to 320 mW.
30. A metrology assembly according to any of clauses 1 - 27, wherein the PCSEL is configured to output pulsed radiation.
31. A metrology assembly according to clause 30, wherein the pulsed radiation has a peak power in a range of 80 mW to 320 W.
32. A metrology assembly according to any of clauses 30 - 31, wherein the pulsed radiation has an average power in a range of 1 mW to 10 W.
33. A metrology assembly according to any of the preceding clauses, wherein the PCSEL is configured to output narrowband radiation or substantially single wavelength radiation.
34. A metrology assembly according to any of the preceding clauses, wherein the PCSEL is configured to output radiation with a wavelength in a range of 250 nm to 1550 nm.
35. A metrology assembly according to clause 34, wherein the PCSEL is configured to output radiation with a wavelength in a range of 400 nm to 900 nm.
36. A metrology assembly according to any of the preceding clauses, wherein the PIC comprises one or more of silicon Si, silicon dioxide SiO₂, indium phosphor InP, silicon nitride SiN, lithium niobate LiNbO₃ structures.
37. A metrology assembly according to any of clauses 1 - 16, and any of clauses 18 - 36 when not dependent on clause 17, wherein the PCSEL is directly attached to a back surface or a front surface of the PIC via flip-chip bonding.
38. A metrology assembly according to any of the preceding clauses, wherein the substrate is a lithographically patterned substrate.
39. A metrology assembly according to any of the preceding clauses, wherein the substrate is a bonded substrate.
40. A metrology assembly according to any of clauses 1- 11, wherein the detector is configured to extract at least one of phase information and amplitude information for determining the parameter.
41. A metrology apparatus comprising a metrology assembly according to any of the preceding clauses.
42. A metrology apparatus of clause 41, wherein the metrology apparatus is a wafer alignment tool.
43. A metrology apparatus of clause 41, wherein the metrology apparatus is an overlay metrology tool.
44. An inspection apparatus comprising a metrology assembly according to any of clauses 1 - 39.
45. A semiconductor processing apparatus comprising a metrology assembly according to any of clauses 1 - 39.
46. A lithography apparatus comprising a metrology assembly according to any of clauses 1 - 39.
47. A litho cell comprising an apparatus according to any of clauses 41 - 46.

Although specific reference may be made in this text to the use of exposure apparatuses, such as lithographic and/or assessment apparatuses used in the process of semiconductor devices, it should be understood that the apparatuses described herein may have other applications. Possible other applications include the process of integrated optical systems, guidance and detection patterns for magnetic domain memories, flat-panel displays, liquid-crystal displays (LCDs), thin film magnetic heads, etc. Embodiments of the invention may be used in other lithographic apparatuses including electron-beam lithographic apparatuses, flat-panel display lithography apparatuses, maskless lithographic apparatuses, (nano)imprint lithographic apparatuses, interference lithography apparatuses, and x-ray lithography apparatus, operable in ambient/ (non-vacuum) and/or in (near)vacuum. Embodiments of the invention may additionally be used in other apparatuses including deposition apparatuses, etching apparatuses, and die-bonding apparatuses.

The lithographic apparatus LA may also be a type of nanoimprint lithographic (NIL) apparatus, which creates patterns by mechanical deformation of imprint resist and subsequent processes. The imprint resist is typically a monomer or polymer formulation that is cured by heat or UV light during the imprinting. Adhesion between the resist and the template may be controlled to allow proper release.

The lithographic apparatus LA may also be a type of maskless lithographic apparatus (MPL), which is configured to project or write a pattern onto a substrate, such as a resist-coated substrate, for example by means of UV or electron beam radiation.

A deposition apparatus may be used to form deposition, for example a thin film or a two-dimensional (2D) material, on the substrate. The deposition may be done by physical vapor deposition (PVD), atomic layer deposition (ALD), liquid phase deposition (LPD), or chemical vapor deposition (CVD). The deposition may be area selective assisted by radiation.

After being processed using the lithocell, the substrate may be further processed by an etching apparatus. During the etching process, layer parts from which resist has been removed during development, are removed. In this way, a pattern is formed on the layer, which may be a hard mask on the substrate. There are two main types of etching methods: wet etching using chemicals and dry etching using plasma. After the etching process, the remaining resist may be removed.

After semiconductor substrates are processed they may further be subject to bonding steps; e.g. an already patterned substrate is bonded to either a blank substrate (fusion bonding) or another patterned substrate (hybrid bonding, for example when at least one of the substrates is provided with electrical contact structures and the other substrate is patterned with (sub) devices). Bonding steps are or may become essential for various semiconductor processing applications, such as processing of 3D NAND, combining chiplets for building heterogeneous (multi-functional) chips or providing separate circuits for logic and power delivery to improve device efficiency (fusion bonding). Both before the bonding step and after the bonding step, lithographic and/or etching patterning steps may be performed to yield bonded semiconductor devices. In addition bonding may be performed between full wafer substrates (wafer to wafer bonding), between dies cut from a wafer (die to die bonding), or between dies and a full wafer substrate (die to wafer bonding). Typically each category of bonding requires the use of a different bonding apparatus (e.g. die to wafer, die to die, or wafer to wafer bonding apparatus).

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

An embodiment may include a computer implemented program containing one or more sequences of machine-readable instructions describing a method. An embodiment may comprise computer code containing one or more sequences of machine-readable instructions or data describing the method. This computer program or code may be executed for example within unit MPU in the apparatus and/or the control unit CL of Figure 3. There may also be provided a data storage medium (e.g., semiconductor memory, magnetic or optical disk, etc.) having such a computer program or code stored therein. Where an apparatus is already in production and/or in use, an embodiment of the invention can be implemented by the provision of an updated computer program product for causing a processor to perform one or more of the methods described herein. The computer program or code may optionally be arranged to control the apparatus to perform a method.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Additional objects, advantages and features of the present invention are set forth in this specification, and in part will become apparent to those skilled in the art on examination of the following, or may be learned by practice of the invention. The inventions disclosed in this application are not limited to any particular set of, or combination of, objects, advantages and features. It is contemplated that various combinations of the stated objects, advantages and features make up the inventions disclosed in this application.

## Claims

1. A metrology assembly for measuring a parameter of a substrate, the metrology assembly comprising:
a photonic crystal surface emitting laser PCSEL configured to output radiation;
a photonic integrated circuit PIC;
wherein:
the PCSEL is directly attached to a back surface of the PIC;
the metrology assembly is configured to direct the radiation from the PCSEL to the substrate; and
the PIC has at least one input coupler configured to capture at least some of the radiation after it has interacted with the substrate; and
a detector configured to receive at least some of the captured radiation from the PIC for measuring the parameter.

2. A metrology assembly according to claim 1, wherein the PIC is configured to receive the radiation from the PCSEL and direct at least some of the radiation to the substrate via at least one output coupler of the PIC.

3. A metrology assembly according to claim 2, wherein the PIC comprises one or more waveguides configured to direct at least some of the radiation received from the PCSEL to the at least one output coupler of the PIC configured to direct the radiation to the substrate.

4. A metrology assembly according to claim 2 or 3, wherein the PIC comprises a plurality of output couplers, and wherein the plurality of output couplers are configured to direct radiation having different angles of incidence onto the substrate.

5. A metrology assembly according to any of the preceding claims, wherein a metamaterial is positioned between an output of the PCSEL and the PIC.

6. A metrology assembly according to any of the preceding claims, wherein the PCSEL is a modulated photonic crystal surface emitting laser M-PCSEL.

7. A metrology assembly according to any of the preceding claims, wherein the PIC comprises one or more reference waveguides configured to guide a portion of the radiation from the PCSEL to one or more reference branches.

8. A metrology assembly according to claim 7, wherein the PIC is configured to interfere the captured radiation from the substrate with the radiation from the one or more reference branches to form an interference pattern on the detector.

9. A metrology assembly according to claim 1, wherein a PIC comprises an opening, wherein the PCSEL is directly attached to the back surface the PIC, and wherein the PCSEL is configured to output radiation through the opening for directing to the substrate.

10. A metrology assembly for measuring a parameter of a substrate, the metrology assembly comprising:
a photonic crystal surface emitting laser PCSEL configured to output radiation;
a photonic integrated circuit PIC;
wherein:
the PCSEL is directly attached to a front surface of the PIC;
the PCSEL is configured to direct at least some of the radiation to the substrate;
the PCSEL is a modulated-photonic crystal surface emitting laser M-PCSEL and/or a metamaterial is placed between an output of the PCSEL and the substrate; and
the PIC has at least one input coupler configured to capture radiation that has interacted with the substrate; and
a detector configured to receive at least some of the captured radiation from the PIC for measuring the parameter.

11. A metrology assembly according to any of the preceding claims, wherein the metrology assembly comprises a plurality of PCSELs.

12. A metrology assembly according to claim 11, wherein at least one PCSEL of the plurality of PCSELs outputs radiation that has a different wavelength to at least one other PCSEL of the plurality of PCSELs.

13. A metrology assembly according to any of the preceding claims, wherein the metrology assembly is configured to detect diffraction orders with angular resolution .

14. A metrology assembly according to any of the preceding claims, wherein the PCSEL is directly attached to a back surface or a front surface of the PIC via flip-chip bonding.

15. A metrology assembly according to any of the preceding claims, wherein the detector is configured to extract at least one of phase information and amplitude information for determining the parameter.
